# EUROPÄISCHE PATENTANMELDUNG

(11) **EP 1 478 217 A2**
(43) Veröffentlichungstag der Anmeldung: **17.11.2004**
(21) Anmeldenummer: 04011242.7
(22) Anmeldetag: 12.05.2004
(51) Int. Cl.: H05K 7/14

(54) **Verbindungselement**

(30) Priorität: 15.05.2003 DE 10321852
(71) Anmelder: Leopold Kostal GmbH & Co. KG, 58507 Lüdenscheid (DE)
(72) Erfinder: Wustlich, André, 59494 Soest (DE); Hütz, Uwe, 58566 Kierspe (DE)

(57) **Zusammenfassung**

Beschrieben wird ein Verbindungselement zur mechanischen und elektrischen Verbindung eines Schaltungsträgers mit einem Gehäuse,
wobei das Verbindungselement als Stift ausgebildet ist und
wobei das Verbindungselement durch eine Öffnung des Schaltungsträgers hindurchgeführt ist, wobei das Verbindungselement mit dem Schaltungsträger verlötet ist, wobei das Verbindungselement mittels eines am Verbindungselement angeformten Widerhakens im Gehäuse verankert ist, und
wobei das Verbindungselement eine Wand des Gehäuses durchragt und außerhalb des Gehäuses einen elektrischen Kontaktstift ausbildet.

## Beschreibung

Die Erfindung betrifft ein Verbindungselement zur mechanischen und elektrischen Verbindung eines Schaltungsträgers mit einem Gehäuse, wobei das Verbindungselement als Stift ausgebildet ist und wobei das Verbindungselement durch eine Öffnung des Schaltungsträgers hindurchgeführt ist.

Aus der deutschen Patentschrift DE 197 35 409 C2 ist eine Verbindungseinrichtung bekannt, bei der ein stiftförmiges Verbindungselement in ein federnd ausgebildetes Kontaktelement verankert ist. Das Kontaktelement ist hierbei mittels eines SMD-Bestückungsautomaten auf der Leiterplatte aufgebracht und mit der Leiterplatte verlötet. Das Verbindungselement bildet ein Teil einer koaxialen Schnittstelle am Gehäuse aus und befestigt zudem die Leiterplatte im Gehäuse.

Es stellte sich die Aufgabe, ein Verbindungselement zu schaffen, welches einfacher und kostengünstiger einen Schaltungsträger innerhalb eines Gehäuses fixiert und nach außerhalb des Gehäuses kontaktiert.

Diese Aufgabe wird erfindungsgemäß dadurch gelöst, daß das Verbindungselement mit dem Schaltungsträger verlötet ist, daß das Verbindungselement mittels eines am Verbindungselement angeformten Widerhakens im Gehäuse verankert ist, und daß das Verbindungselement eine Wand des Gehäuses durchragt und außerhalb des Gehäuses einen elektrischen Kontaktstift ausbildet.

Vorteilhaft gegenüber der aus dem Stand der Technik vorbekannten Verbindungseinrichtung ist insbesondere, daß das Verbindungselement gleichzeitig einstückig das Kontaktelement zur Anbindung am Schaltungsträger ausbildet.

Vorteilhaft ist auch, daß die in die Gehäusewand eingedrückten Stifte das Gehäuse vollständig abdichten. Hierdurch wird ein Eindringen von Staub und Wasser in das Gehäuse verhindert. Außerdem wird ein vollständiges Vergießen der im Gehäuseinneren angeordneten Elektronik möglich.

Ein Ausführungsbeispiel der erfindungsgemäßen Schaltungsanordnung ist in der Zeichnung dargestellt und wird im folgenden anhand der Zeichnung näher erläutert.

Es zeigen
Figur 1 ein erfindungsgemäßes Verbindungselement vor der Montage und
Figur 2 ein erfindungsgemäßes Verbindungselement nach erfolgter Montage.

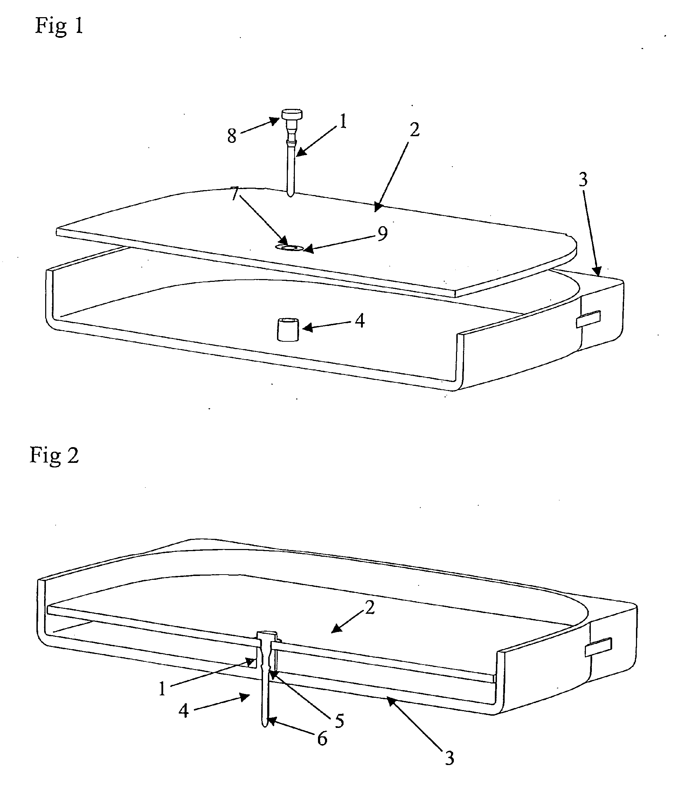

In der Figur 1 ist ein Verbindungselement (1) dargestellt, sowie ein ebener Schaltungsträger (2), der beispielspielsweise als Leiterplatte oder als Hybridkeramik ausgebildet sein kann, sowie ein Gehäuseteil (3) mit einer einstückig angeformten hülsenförmigen Anformung (4).

Das Verbindungselement (1) ist so ausgeführt, daß es mittels eines SMD-Bestückungsautomaten in eine Öffnung des Schaltungsträgers (2) eingesetzt werden kann. Das Verbindungselement (1) weist weiterhin einen zylinderförmigen Kopf auf, der vorzugsweise mittels Reflow-Lötung mit einem um die Öffnung herum angeordneten Lötring verbunden werden kann.

Wie die Figur 2 zeigt, ist das mit dem Schaltungsträger (2) verlötete Verbindungselement (1) im montierten Zustand durch eine Ausnehmung in einer Wand des Gehäuses (3) geführt, wobei ein widerhakenförmiger Abschnitt (5) des stiftförmigen Verbindungselementes (1) mit einer hülsenförmigen Anformung (4) auf der Innenseite der Gehäusewand verrastet ist.

Das Verbindungselement (1) fixiert so auf einfache und kostengünstige Weise den Schaltungsträger (2) innerhalb des Gehäuses. Ein die Gehäusewand durchragender Endabschnitt des Verbindungselements (1) bildet gleichzeitig einen Kontaktstift (6) aus, der eine elektrische Verbindung zum Schaltungsträger (2) herstellt.

In einer in der Zeichnung nicht dargestellten Weiterung können selbstverständlich mehrere nebeneinander angeordnete Verbindungselemente vorgesehen werden, die auf der Außenseite des Gehäuses einen mehrpoligen Stecker ausbilden. An der Gehäuseaußenwand kann dementsprechend zudem eine kragenförmige Anformung vorgesehen sein, die einen Steckerkorb ausbildet.

### Bezugszeichen

- 1: Verbindungselement
- 2: Schaltungsträger
- 3: Gehäuseteil
- 4: hülsenförmige Anformung
- 5: Widerhaken
- 6: Kontaktstift

## Patentansprüche

1. Verbindungselement zur mechanischen und elektrischen Verbindung eines Schaltungsträgers mit einem Gehäuse,
wobei das Verbindungselement als Stift ausgebildet ist und
wobei das Verbindungselement durch eine Öffnung des Schaltungsträgers hindurchgeführt ist,
**dadurch gekennzeichnet,**
- **daß** das Verbindungselement (1) mit dem Schaltungsträger (2) verlötet ist,
- **daß** das Verbindungselement (1) mittels eines am Verbindungselement (1) angeformten Widerhakens (5) im Gehäuse (3) verankert ist,
- und **daß** das Verbindungselement (1) eine Wand des Gehäuses (3) durchragt und außerhalb des Gehäuses (3) einen elektrischen Kontaktstift (6) ausbildet.

2. Verbindungselement (1) nach Anspruch 1, **dadurch gekennzeichnet, daß** das Verbindungselement (1) mittels Reflow-Lötung mit dem Schaltungsträger (2) verbunden ist.

3. Verbindungselement (1) nach Anspruch 1, **dadurch gekennzeichnet, daß** das Verbindungselement (1) auf dem Schaltungsträger (2) SMD-bestückbar ist.

4. Verbindungselement (1) nach Anspruch 1, **dadurch gekennzeichnet, daß** das Verbindungselement (1) mit einer hülsenförmigen Anformung (4) des Gehäuses (3) verrastet ist.

5. Verbindungselement (1) nach Anspruch 1, **dadurch gekennzeichnet, daß** ein Abschnitt des Verbindungselements (1) außerhalb des Gehäuses (3) einen Kontaktstift (6) ausbildet.
